# EUROPEAN PATENT APPLICATION

(11) **EP 4 435 508 A1**
(43) Date of publication of application: **25.09.2024**
(21) Application number: 23163326.4
(22) Date of filing: 22.03.2023
(51) Int. Cl.: G02F 1/35

(54) **INTEGRATED CIRCUIT FOR GENERATING A FREQUENCY COMB SIGNAL, OPTICAL SYSTEM AND TEST AND MEASUREMENT DEVICE**

(71) Applicant: Rohde & Schwarz GmbH & Co. KG, 81671 München (DE)
(72) Inventor: Ruengeler, Matthias, 85551 Kirchheim (DE); Hechtfischer, Gerd, 85591 Vaterstetten (DE); Scheffter, Michael, 83052 Bruckmuehl-Heufeldmuehle (DE); Eichler, Taro, 81241 München (DE); Dettmann, Ingo, 81539 München (DE)
(74) Representative: Isarpatent

(57) **Abstract**

The present invention relates to an integrated circuit, in particular a photonic integrated circuit, for generating an electrical and/or optical frequency comb signal, the integrated circuit comprising: a pulse generation unit comprising an input port for receiving an optical high frequency signal. The present invention provides a Kerr-ring for the generation of an optical frequency comb signal. The use of the Kerr-ring for the optical frequency comb generation makes the integration possible. The present invention further relates to an optical system and a test and measurement device.

## Description

### FIELD OF THE INVENTION

The present invention relates to an integrated circuit, in particular a photonic integrated circuit, for generating an electrical and/or optical frequency comb signal. The present invention further relates to an optical system and a test and measurement device.

### TECHNICAL BACKGROUND

For phase- and amplitude-calibration of spectrum analyzers or oscilloscopes, a known reference is often necessary for providing a faster phase and amplitude calibration. This calibration should further be done preferably onsite and not only by means of a factory alignment.

For the generation of a known reference for phase- and amplitude-calibration, a so-called comb signal, such as a Dirac comb, can be used. The Dirac comb (also known as shah function, impulse train or sampling function) describes a periodic sequence of Dirac impulses that has the shape of a comb. The Dirac comb is often used in signal processing by means of Fourier analysis. In the time domain the Dirac comb represents a train of Dirac pulses which result in the frequency domain to equidistant "pickets" of known amplitude and phase. When using a baseband comb, the bandwidth or "picket" with the highest frequency is usually limited.

Another challenge is the power of each of these "pickets". There is often the need for a very fine frequency grid, however, with a finer frequency grid, the repetition frequency in the time domain is lower and thus fewer Dirac impulses contribute to the total power.

This can be overcome by using a very high repetition frequency of the Dirac pulses in the time domain (e.g. in the range of 2-10 GHz) and employing a smart canceling out mechanism for damping or cancelling a good portion of the impulses of the Dirac comb. When employing a smart cancelling out sequence (such as a so-called PRBS-sequence), this results in a very fine frequency grid with "pickets" with known amplitude and phase.

According to another approach for the generation of the electrical train of Dirac pulses, a pulsed laser together with a photo diode is employed. This leads to comparably great bandwidths in the range of 100 GHz, however, it results in comparably small power per "picket".

US 10,707,968 B2 describes a frequency comb generation device, which combines the above-mentioned two approaches. Accordingly, the frequency comb generation device combines the optical generation of the Dirac train and the cancelling out mechanism of the Dirac pulses in the optical domain and as such combines the benefits of a high bandwidth and at the same time a high output power.

Presently existing optical signal generation devices, such as described above, were miniaturized only to a limited extent, mainly because the currently used optical devices, such as lasers, cannot or can only with great difficulty be integrated in a semiconductor material.

### SUMMARY OF THE INVENTION

Against this background, there is a need for an optimized generation of a high frequency comb signal.

Accordingly, the present invention provides an integrated circuit having the features of claim 1 and/or by an optical system having the features of claim 14 and/or by a test and measurement device having the features of claim 15.

According thereto, there is provided:
- An integrated circuit, in particular a photonic integrated circuit, for generating an electrical and/or optical frequency comb signal, the integrated circuit comprising: a pulse generation unit comprising an input port for receiving an optical high frequency signal wherein the pulse generation unit comprises at least one Kerr-ring which is arranged and configured such to generate an optical comb signal from the received optical high frequency signal.
- An optical system, the optical system comprising: at least one integrated circuit according to the present invention, and at least one optical component which is connected to the integrated circuit via an optical or electrical interface, wherein the at least one optical component comprises at least one of the following: an external laser connected via an optical input terminal to the pulse generation unit of the integrated circuit and which is configured to generate an optical high frequency signal; at least one external photodiode connected via an optical output terminal to the integrated circuit.
- A test and measurement device comprising the integrated circuit according to the present invention and/or the optical system according to the present invention.

The present invention is based on the idea to provide a Kerr-ring for the generation of an optical frequency comb signal. It is the use of this Kerr-ring for the optical frequency comb generation that made integration possible.

A Kerr-ring denotes a circular type optical waveguide. In particular, a Kerr-ring is a kind of a non-linear ring resonator within an optical integrated circuit that has nonlinear properties. Due to these nonlinear properties, a short, stable non-linear pulse is generated within the ring resonator. This pulse is also known as soliton or solitary wave. A soliton or solitary wave is a self-reinforcing wave packet that maintains its shape while it propagates at a constant velocity. Solitons are caused by a cancellation of nonlinear and dispersive effects in the medium.

Summarizing the result, the present invention aims to miniaturize the know concepts for the generation of high frequency comb signals, such as the one described in the technical background. Preferably, all components or at least most of them fit on a single semiconductor chip. This enables significantly higher repetition rates and much lower form factors as in presently known systems.

Furthermore, by integration of the Kerr-ring into a specific semiconductor material, it is now possible to provide comparably small and therefore significantly cheaper devices for the generation of high frequency comb signals.

For a particular preferred embodiment, the same material system is used for the integrated circuit or optical integrated circuit system. For the substrate of the integrated circuit and as such for the material system, any kind of semiconductor material may be used, such as a silicon based materials, in particular monocrystalline silicon, silicon carbide, silicon nitride (Si₃N₄), or non silicon-based material systems, such as lithium niobate (LiNbOs) or gallium arsenide (GaAs). Additionally, a diamond based material may be used. However, it may also be productive for some embodiments if different material systems which may comprise a mixture or combination of the above mentions materials are used for the different components of the optical integrated circuit and/or the optical system.

The test and measurement device according to the present invention may be any optical test and measurement apparatus, a network analyzer, an oscilloscope, a wireless communication tester. The invention may also be implemented in or used for signal generators, broadband amplifiers, radio system components, etc.

Advantageous configurations and developments emerge from the further dependent claims and from the description with reference to the figures of the drawings.

In a particular preferred embodiment, the integrated circuit further comprises an optical modulator. The optical modulator is preferably integrated in the same semiconductor substrate of the pulse generation unit and is further connected to the pulse generation unit for receiving the generated optical comb signal. The optical modulator is configured to generate a modulated optical comb signal based on a modulation control signal. Using the modulation technique, the repetition rate can be modified, for example, by only allowing every second pulse of a 100 MHz signal to pass by suitable attenuation, a finer spectrum or repetition rate of, for example, 50 MHz is obtained.

In a particular preferred embodiment, lithium niobate (LiNbO₃) or silicon nitride can be used a preferred material system for the Kerr-ring or Kerr-mircorings. Lithium niobate is a transparent, crystalline solid that may be grown from a melt by the Czochralski process. Its single crystals are an important material for optical waveguides, mobile phones, piezoelectric sensors, optical modulators and various other linear and non-linear optical applications. Lithium niobate is sometimes referred to linobate. Additionally, the material of the Kerr-ring may also be silicon nitride.

In one embodiment, the Kerr-ring of the pulse generation unit and/or the optical modulator are completely or at least partially integrated within the material of the semiconductor substrate. For this embodiment, the Kerr-ring may be produced using commonly known semiconductor manufacturing technologies, such as implanting, doping, lithography, etching, sputtering, etc. In an alternative embodiment, the Kerr-ring and/or the optical modulator are provided and thus fixedly attached on a surface of the semiconductor substrate. For this embodiment, the Kerr-ring may be deposited or bonded on the surface for example by deposition techniques, such as sputtering and bonding, respectively.

In a particular preferred embodiment, at least two Kerr-rings are provided. In particular, the at least two Kerr-rings may be arranged in parallel to each other. This kind of redundancy allows manufacturing tolerances to be compensated for in a very simple manner and thus order ensure a high signal quality an. Alternatively or additionally, the at least two Kerr-rings may be arranged in cascade or parallel to each other.

In one particular preferred embodiment, the integrated circuit further comprises an integrated laser, which is configured to generate the optical high frequency signal for the pulse generation unit. Preferably, the integrated laser is a continuous-wave (CW) laser. Unlike conventional pulse lasers, a CW laser emits a light wave of constant intensity. In the present example, the CW laser emits a light wave with a wavelength of 800nm or 1550nm..

In one further and particular preferred embodiment, the integrated circuit further comprises a sequence generation unit connected to a control input of the optical modulator. The sequence generation is configured to generate the modulation control signal for controlling the optical modulator. In a further preferred embodiment, the sequence generation unit is integrated in the same semiconductor material of the optical modulator and the Kerr-ring of the pulse generation unit. Consequently, all optical components of the test and measuring device - or at least most of them - fit on a single semiconductor chip.

In one aspect of the invention, the sequence generation unit is configured to receive a control signal on the basis of which the sequence generation unit produces the modulation control signal. The received control signal may comprise a sequence reset information and/or an information related to the sequence configuration.

In a particular preferred configuration, the sequence generation unit is configured to generate a PRBS (Pseudorandom Binary Sequence) signal. The pseudorandom binary sequence, that can take the values +1 and -1, is a binary signal that approximates the spectrum of white noise and that may be generated by a deterministic random number generator. The advantage of the PRBS is the reproducibility of the signal. It is used in communications engineering for code division multiplexing, band spreading, encryption and transmission channel checking, and the like. A PRBS can be generated with a linear feedback shift register. The PRBS signal generated by the sequence generation unit is part of the modulation control signal and is used for controlling the modulation of the optical modulator. Instead of a PRBS signal, the modulation control signal may also comprise equally distanced "1" within "0", a combination of the PRBS with the equally distanced "1" within "0". The modulation control signal may also be any arbitrary sequence of "0" and "1". The PRBS sequence provides a repeating bit sequence that has certain settable properties. For example, it can be set that the PRBS changes every 15 bits. This results in a corresponding number of additional comb lines of the same amplitude in the characteristic curve such that a finer repetition rate or spectrum is possible.

According to an additional or alternative configuration, the sequence generation unit is configured to operate the optical modulator in a divider mode and/or in an arbitrary mode.

According to a further aspect, the sequence generation unit is configured to generate at least one modulation control signal that causes the optical modulator to generate modulated optical comb signals having two different power levels, such as "0" and "1", or preferably more than two different power levels, such as "0", "1" and "0,5". Additionally or alternatively, the sequence generation unit is configured to generate at least one modulation control signal that causes the optical modulator to generate modulated optical comb signals having at least two discrete time shifts. in this way, the delay of the modulation signal can be controlled.

According to still another aspect, the sequence generation unit further comprises at least one control input for configuring and controlling the operation of the sequence generation unit. The control input of the sequence generation unit is coupled preferably to the pulse generation unit, a reset unit, a sequence configuration unit and/or an external terminal for receiving an externally generated control signal.

The integrated circuit according to the present invention further comprises in one aspect one first photodiode for generating an electrical comb signal from the modulated optical comb signal. The first photodiode that is preferably a broadband photodiode. The photodiode generates very fast, broadband electrical pulses when triggered with a repetition rate of, for example, 100 MHz of the optical laser. In this way, a characteristic curve is obtained in the electrical spectrum every 100 MHz, which has a known phase. The integrated circuit may comprise at least one second photodiode that is arranged in parallel to the first photodiode. The second photodiode is for example of the same type as the first photodiode, e.g. a broadband photodiode, or a narrowband photodiode. The first and second photodiodes are preferably integrated within the same semiconductor material.

The integrated circuit according to the present invention further comprises at least one optical splitter which may be connected downstream the optical modulator and an optical output terminal connected to the optical splitter. The splitter may be used for splitting the modulated optical comb signal between an internal signal provided to at least one photodiode within the semiconductor substrate and an external signal provided to an external device, e.g. an external photodiode.

According to another configuration, at least one further optical modulator is provided connected to the pulse generation unit for receiving the generated optical comb signal. The further optical modulator, which may be identical or at least similar to the optical modulator is connected to or connectable to different photodiode as the optical modulator, in particular via an output terminal to an external photodiode. Additionally or alternatively, the further optical modulator is configured to receive another modulating control signal or the same modulation signal from the sequence generation unit. By employing a further optical modulator, a redundancy is provided for the output signals, which, in case the regular optical modulator is not working properly, is preferred.

According to still another configuration, at least one second photodiode connected to the sequence generation unit is provided. The sequence generation unit is configured to generate a timing trigger signal for the second photodiode every time a new sequence is generated.

According to another configuration, at least one third photodiode directly connected to the output terminal of the pulse generation unit is provided. The third photodiode is used for providing an electrical clock signal or reference signal based on the non-modulated optical comb signal.

According to a preferred configuration, the integrated circuit comprises a phased-locked loop circuit, which is configured to control the frequency of the pulse generation unit and/or of the integrated laser.

According to a further configuration, the integrated circuit comprises an external optical input port for receiving an external optical signal and a switching unit. In a first switching mode the switching unit is configured to connect the optical modulator (and/or further optical modulator) to a first photodiode, and in a second switching mode the switching unit is configured to connect the external optical input port to the first photodiode.

In a preferred aspect, at least one input terminal for receiving a control signal for controlling the operation of the sequence generation unit and/or for receiving a reference clock signal is provided.

The above embodiments can be combined with each other as desired, if useful. Further possible embodiments, further configurations and implementations of the invention also include combinations, not explicitly mentioned, of features of the invention described herein with respect to the embodiments. In particular, the skilled person will thereby also add individual aspects as improvements or additions to the respective basic form of the present invention.

### BRIEF DESCRIPTION OF THE EMBODIMENTS

For a more comprehensive understanding of the invention and the advantages thereof, exemplary embodiments of the invention are explained in more detail in the following description with reference to the accompanying drawing figures, in which like reference characters designate like parts and in which:
- Fig. 1: shows a cross section view illustrating a generic embodiment of the integrated circuit according to the present invention;
- Fig. 1A: shows a cross section view illustrating a further generic embodiment of the integrated circuit according to the present invention;
- Fig. 2: shows a preferred embodiment of a pulse generation unit formed as a Kerr-ring;
- Fig. 3: shows a block diagram of a further embodiment of an integrated circuit according to the present invention;
- Fig. 4: shows a block diagram of an embodiment of an optical system according to the present invention; and
- Fig. 5: shows a block diagram of a further embodiment of an optical system according to the present invention;
- Fig. 6: shows a block diagram of a further embodiment of an optical system according to the present invention;
- Fig. 7: shows a block diagram of an embodiment of a test and measurement device according to the present invention.

The accompanying drawings are included to provide a fur-ther understanding of the present invention and are incorporated in and constitute a part of this specification. The drawings illustrate particular embodiments of the invention and together with the description serve to explain the principles of the invention. Other embodiments of the invention and many of the resulting advantages of the invention will be readily appreciated, as they become better understood with reference to the following detailed description.

It will be appreciated that common and/or well understood elements that may be useful or necessary in a commercially feasible embodiment are not necessarily depicted in order to facilitate a more abstracted view of the embodiments. The elements of the drawings are not necessarily illustrated to scale relative to each other. It will further be appreciated that certain actions and/or steps in an embodiment of a method may be described or depicted in a particular order of occurrences while those skilled in the art will understand that such specificity with respect to sequence is not actually required. It will also be under-stood that the terms and expressions used in the present specification have the ordinary meaning as is accorded to such terms and expressions with respect to their corresponding respective areas of inquiry and study, except where specific meanings have otherwise been set forth herein.

### DETAILED DESCRIPTION OF THE EMBODIMENTS

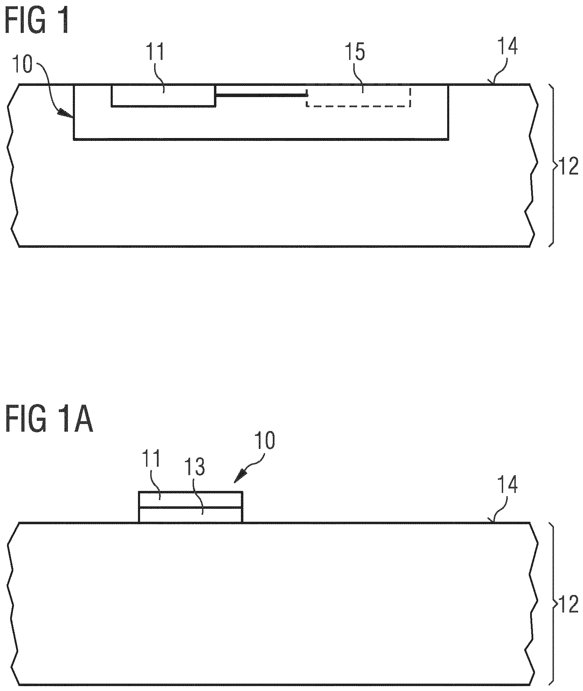

Figs. 1, 1A show cross section views illustrating generic embodiments of the integrated circuit 10 according to the present invention.

In Fig. 1, the integrated circuit 10 for generating a frequency comb signal is denoted by reference numeral 10. The integrated circuit 10 comprises amongst other components (not shown in Fig. 1) a pulse generation unit 11 that comprises at least one Kerr-ring.

According to the present invention, the pulse generation unit 11 and thus its at least one Kerr-ring is completely integrated and thus embedded within a semiconductor substrate 12 using known semiconductor technologies. The semiconductor substrate 12 can be a silicon substrate.

In another embodiment shown in Fig. 1A, the pulse generation unit 11 and thus its Kerr-ring is attached via a non-detachable connection 13 on a surface 14 of the semiconductor substrate 12. The non-detachable connection 13 may be a bonding connection, a thermally grown material, a deposited material or the like.

In an additional embodiment the integrated circuit 10 may comprise an optical modulator 15 (shown in dotted lines in Fig. 1), whichis connected to the pulse generation unit 11, and which is integrated in the same semiconductor substrate 12.

In a preferred embodiment, the integrated circuit 10 shown in Figs. 1, 1A is a so-called photonic integrated circuit (PIC) or integrated optical circuit. A PIC is a microchip containing two or more photonic components, which form a functional circuit. This technology detects, generates, transports, and processes light. PIC utilize photons (or light particles) as opposed to electrons that are utilized by electric or electronic integrated circuits (ICs).

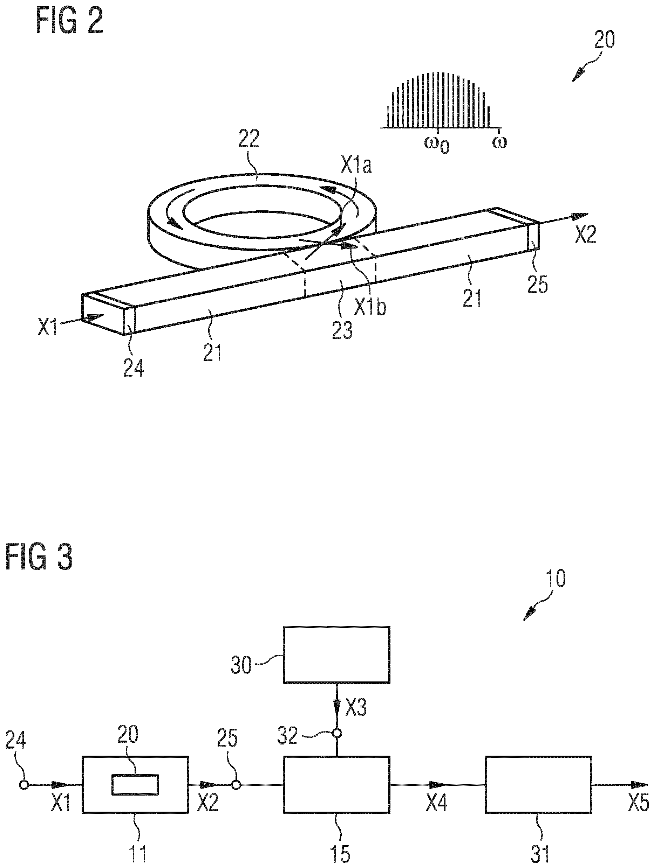

Fig. 2 shows a preferred embodiment of a pulse generation unit 11 formed as a Kerr-ring, which is bonded on the semiconductor substrate 12 analogously to the embodiment shown in Fig. 1A.

The Kerr-ring 20 consists of a linear light guide section 21 and a circular light guide section 22. Both light guide sections 21, 22 are connected to each other at a contact section 23. One end 24 of the linear light guide section 21 functions as an input terminal and the second end 25 functions as an output terminal. The input terminal 24 is used for receiving an optical high frequency signal X1. The high frequency signal X1 propagates along the linear light guide section 21 until the contact section 23 is reached. At the contact section 23, at least a portion X1a of the high frequency signal X1 branches towards the circular light guide section 22 while the remaining portion of the high frequency signal X1 keeps propagating along the linear light guide section 21. The branched off signal enters the circular light guide section 22 and continues to propagate around the circular light guide section 22 with suitable energy input. Due to non-linear properties of the material of the light guide in connection with the refractive index at the walls of the circular light guide section 22, a pulsed wave signal is generated which continues to propagate around in the circular light guide section 22 as a pulsed wave in the time domain. In the frequency domain, this results in the desired frequency comb. This pulsed wave signal X1b reenters the linear light guide section 21 at the contact section 23 such that at the output terminal 25 the pulsed wave signal X2 having the desired frequency comb characteristic is provided.

Fig. 3 shows a block diagram of a further embodiment of an integrated circuit 10 according to the present invention.

The integrated circuit 10 comprises the pulse generation unit 11 that comprises the integrated Kerr-ring 20, the optical modulator 15, a sequence generation unit 30 and a photodiode 31.

The input terminal 24 of the pulse generation unit 11 is used for receiving an optical high frequency signal X1 that is for example generated by an external light source (not shown in Fig. 3), such as a laser.

The pulse generation unit 11 is connected via its output terminal 25 to the optical modulator 15. The optical modulator 15 comprises a control terminal 32 that is connected to the sequence generation unit 30. The sequence generation unit 30, which is integrated in the same semiconductor substrate, is configured to generate a modulation control signal X3. This modulation control signal X3 is used to control the modulation characteristics within the optical modulator 15. The optical modulator 15 which receives via (output) terminal 25 the optical pulsed wave signal X2 is configured to generate a modulated optical comb signal X4 based on the modulation control signal X3.

The generated modulated optical comb signal X4 is provided to the photodiode 31 connected downstream of the optical modulator 15. The photodiode 31, which is integrated in the same semiconductor substrate, is preferably a broadband photodiode and is configured to emit an electrical signal X5 that shows the desired high frequency comb characteristic.

In a preferred embodiment, the sequence generation unit 30 is configured to generate a PRBS signal X3 having predefined PRBS bit sequence. In PRBS mode, the sequence generation unit 30 generates the PRBS control signal in such a way that each pulse is passed. With a repetition rate of 100 MHz, a spectral line for the optical comb signal is thus obtained in the spectrum every 100 MHz.

In another embodiment, the sequence generation unit 30 may also be operated to support a divider mode. In the divider mode, only one pulse is passed ("1") followed by a predefined number of non-passed or suppressed pulses ("0"). This way, the sequence generation unit 30 generates a control signal such to divide the frequency of the repetition rate. For example, by allowing to pass only every second pulse, a frequency of 50 MHz can be set at a repetition rate of 100 MHz, and by allowing to pass every third pulse, a frequency of 33,3 MHz can be set at a repetition rate of 100 MHz. That is, setting a predefined amount of "0" following a "1" allows a desired frequency raster to be set. This may be implemented by a comparable simple logic circuit within the sequence generation unit 30, such as an up-counter or a down-counter.

In another embodiment, the sequence generation unit 30 may also be operated to support an arbitrary mode. In the arbitrary mode, a specific bit sequence of a given length is defined. This makes it possible to generate a fully flexible, user-defined frequency raster at a given repetition rate. However, the arbitrary mode may typically be not implemented by means of a simple logic device, since one usually would need at least a memory device for this purpose. Therefore, the corresponding circuitry is usually arranged externally to the integrated circuit 10. Due to the high setting flexibility of the arbitrary mode, the arbitrary mode typically covers the PRBS mode and the divider mode either.

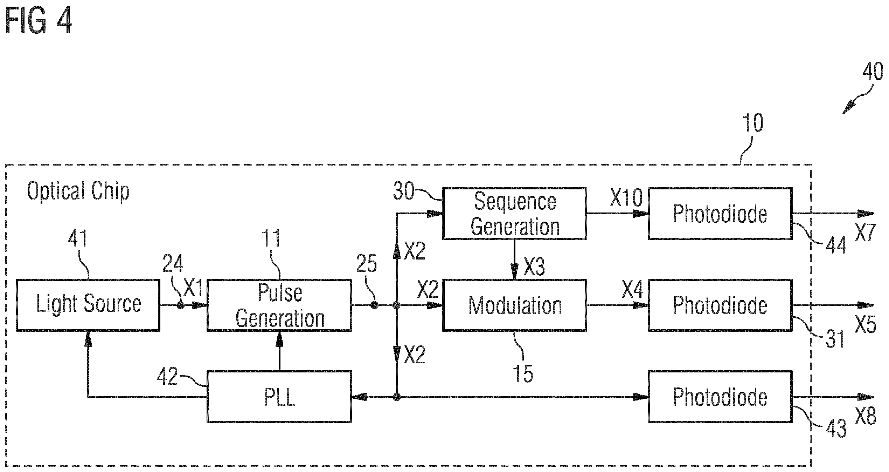

Fig. 4 shows a block diagram of an embodiment of an optical system 40 according to the present invention.

In Fig. 4, the optical system is denoted by reference 40. The optical system 40 comprises, in particular, an integrated circuit 10.

In addition to the embodiment example of Fig. 3, the integrated circuit 10 in Fig. 4 comprises a light source 41, a PLL 42 and two further photodiodes 43, 44.

The light source 41 is an integrated optical source 41, which can be designed, for example, as a continuous-wave laser. The light source 41 is directly coupled to the pulse generation unit 11 via the terminal 24 and is configured to generate the optical high frequency signal X1 for the pulse generation unit 11.

The phased-locked loop (PLL) 42 is coupled with its input side to the output terminal 25 of the pulse generation unit 11 and with its output side to corresponding control inputs of the light source 41 and the pulse generation unit 11. This enables the PLL to control the wavelength of the optical signal X1 generated by the integrated light source 41 and/or to control the frequency of the pulsed wave signal X2 generated by the pulse generation unit 11, respectively. Employing the PLL 42 ensures that an exact repetition rate of the optical signal is set for use in the modulator 15 or sequence generator 30.

For synchronizing the sequence generation unit 30 to the system clock and phase, the pulsed wave signal X2 is fed into the sequence generation unit 30.

The two further photodiodes 43, 44 may be narrowband photodiodes. In a preferred embodiment, however, the two photodiodes 43, 44 are of the same type as photodiode 31. According to a particular preferred implementation, all photodiodes 31, 43, 44 are broadband photodiodes. This way, one and the same semiconductor technology process may be applied for the production of all photodiodes 31, 43, 44 which is cost efficient.

One of the photodiodes 44 is connected to the sequence generation unit 30 for receiving a trigger signal X10. The sequence generation unit 30 generates this trigger signal X10 every time the (PRBS) sequence is started again. The photodiode 44 is then configured to emit a corresponding electrical trigger signal X7, which indicates when the sequence is repeated and thus provides a timing information. This trigger signal X7 may be used in an external network analyser or spectral analyser for obtaining an absolute phase reference between the control signal X3 and the electrical signal X5 and a delay information of the signals through a device under test (DUT).

The other photodiode 43 is connected via the output terminal 25 to the pulse generation unit 11. Photodiode 43 is configured to emit an electrical output signal X8 based on the original optical signal X2, which indicates the original repetition rate and thus provides a clock reference. In this way, the original optical signal X2 is fed out as a clock signal, which can then be evaluated by an external device such as a spectrum analyzer or network analyser (not shown in Fig. 4). These external devices need this clock information as a reference to know on which system clock the integrated circuit 10 is operating.

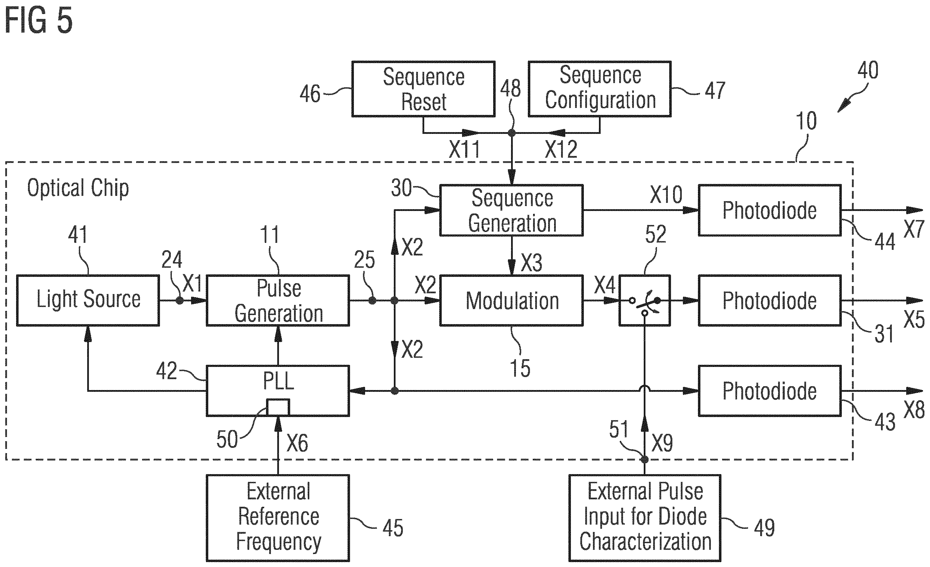

Fig. 5 shows a block diagram of a further embodiment of an optical system 40 according to the present invention.

The optical system 40 in Fig. 5 further comprises a reset unit 46 and a configuration unit 47 which are both coupled to a control interface 48 of the sequence generation unit 30.

The configuration unit 46 is configured to generate a reset signal X11 that comprises a sequence reset information. This makes it possible to reset the setting set in the sequence generation unit 30, for example to a default setting.

The configuration unit 47 is configured to generate a configuration signal X12 that comprises an information related to the sequence configuration. This makes it possible to set a specific operating mode with which the sequence generation unit 30 is operated, e.g. a PRBS mode, a divider mode, an arbitrary mode or any other user defined mode.

While in the embodiment in Fig. 5, the configuration unit 46 and the configuration unit 47 are arranged outside the integrated circuit 10, in a preferred embodiment they may also be integrated within the integrated circuit 10.

The PLL 42 comprises a clock input terminal 50, which is connected to an external clock generator 45. The external clock generator 45 is configured to provide a reference frequency X6 for the PLL 42.

The optical system 40 also comprises a unit 49, which is connected via an input terminal 51 to the integrated circuit 10. The unit 49 is configured to generate an external reference pulse signal X9 that may be provided to the photodiode 31. This pulse signal X9 is configured such to allow diode characterization of photodiode 31. For this purpose, the integrated circuit 10 comprises a switch 52. The two input terminals of the switch 52 are connected to the optical modulator 15. The output terminal of the switch 52 is connected to the photodiode 31. In this way, photodiode 31 may be operated in a normal operation mode based on the modulated optical comb signal X4 and in diode characterization mode based on the reference pulse signal X9.

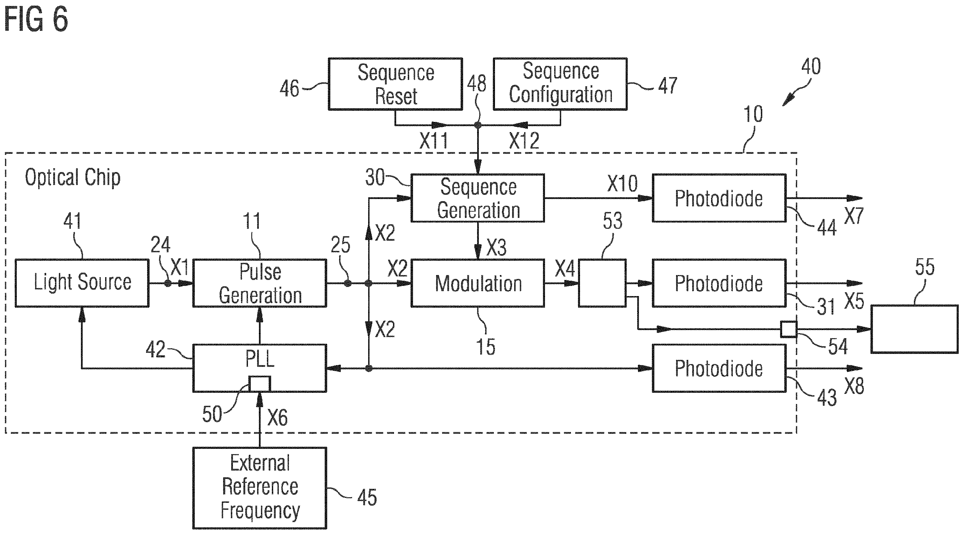

Fig. 6 shows a block diagram of a further embodiment of an optical system 40 according to the present invention.

A splitter 53 is provided between the optical modulator 15 and the photodiode 31. The splitter 53 is configured to split feed the modulated optical comb signal X4 either to photodiode 31 or via an output terminal 54 to an externally arranged further photodiode 55. This allows the modulated signal not to be led out of the integrated circuit 10 via the integrated photodiode 31, which is advantageous if, for example, the integrated photodiode 31 is defective, too inaccurate or cannot be used for high-precision applications due to manufacturing tolerances. In those cases, the external photodiode 55 which may be optimized for the specific application can be used.

In other embodiments (not shown in the figures), for example for the same reasons a redundancy may be used for at least one of the photodiodes 31, 43, 44, for example by providing one or mode additional photodiodes which are arranged parallel to the corresponding photodiodes 31, 43, 44.

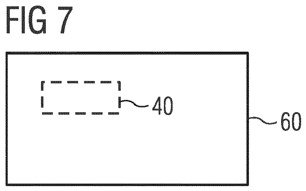

Fig. 7 shows a block diagram of an embodiment of a test and measurement device 60 according to the present invention. The test and measurement device 60 comprises an optical system 40 such as the one shown in Fig. 4. The test and measurement device 60 can alternatively also comprise only an integrated circuit 10 (in Fig. 5 shown in dotted lines) such as the one shown in any of the Figs. 1, 1A, 3, 4.

The test and measurement device 50 may be a spectrum analyser, a network analyzer, an oscilloscope, a wireless communication tester or the like. The invention may also be implemented in or used for signal generators, broadband amplifiers, radio system components, etc.

In the foregoing specification, the invention has been described with reference to specific examples of embodiments of the invention. It will, however, be evident that various modifications and changes may be made therein without departing from the broader spirit and scope of the invention as set forth in the appended claims. For example, the connections between various elements as shown and described with respect to the drawings may be a type of connection suitable to transfer optical and/or electrical signals from or to the respective nodes, units or devices, for example via intermediate devices. Accordingly, unless implied or stated otherwise the connections may for example be direct connections or indirect connections.

As the apparatuses implementing the present invention are, for the most part, composed of electronic components and circuits individually known to those skilled in the art, details of the circuitry and its components will not be explained in any greater extent than that considered necessary as illustrated above, for the understanding and appreciation of the underlying concepts of the present invention and in order not to obfuscate or distract from the teachings of the present invention.

In the description, any reference signs shall not be construed as limiting the claim. The word "comprising" does not exclude the presence of other elements or steps then those listed in a claim. Furthermore, the terms "a" or "an", as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements. The mere fact that certain measures are recited in mutually different claims does not indicate that a combination of these measures cannot be used to advantage.

Skilled artisans will appreciate that the illustrations of chosen elements in the drawings are only used to help to improve the understanding of the functionality and the arrangements of these elements in various embodiments of the present invention. Also, common and well understood elements that are useful or necessary in a commercially feasible embodiment are generally not depicted in the drawings in order to facilitate the understanding of the technical concept of these various embodiments of the present invention. It will further be appreciated that certain procedural stages in the described methods may be described or depicted in a particular order of occurrence while those skilled in the art will understand that such specificity with respect to sequence is not actually required.

### LIST OF REFERENCE SIGNS

- 10: integrated circuit
- 11: pulse generation unit
- 12: semiconductor substrate
- 13: connection
- 14: surface
- 15: optical modulator
- 20: Kerr-ring
- 21: linear light guide section
- 22: circular light guide section
- 23: contact section
- 24: input terminal
- 25: output terminal
- 30: sequence generation unit
- 31: photodiode
- 32: control terminal
- 40: optical system
- 41: light source
- 42: PLL
- 43: photodiode
- 44: photodiode
- 45: clock generator
- 46: reset unit
- 47: configuration unit
- 48: control interface
- 49: unit
- 50: clock input terminal
- 51: input terminal
- 52: switch
- 53: splitter
- 54: output terminal
- 55: (externally arranged) photodiode
- 60: test and measurement device
- X1: optical high frequency signal
- X1a: portion of the high frequency signal
- X2: pulsed wave signal
- X3: modulation control signal
- X4: modulated optical comb signal
- X5: electrical signal
- X6: reference frequency
- X7: trigger signal
- X8: output signal
- X9: reference pulse signal
- X10: trigger signal
- X11: reset signal
- X12: configuration signal

## Claims

1. Integrated circuit, in particular photonic integrated circuit, for generating an electrical and/or optical frequency comb signal, the integrated circuit comprising:
a pulse generation unit comprising an input port for receiving an optical high frequency signal wherein the pulse generation unit comprises at least one Kerr-ring, which is arranged and configured to generate an optical comb signal from the received optical high frequency signal.

2. Integrated circuit according to claim 1,
further comprising an optical modulator, which is connected to the pulse generation unit for receiving the generated optical comb signal, wherein the optical modulator is configured to generate a modulated optical comb signal based on a modulation control signal.

3. Integrated circuit according to any of the preceding claims, wherein the material of the Kerr-ring is lithium niobate or silicon nitride.

4. Integrated circuit according to any of the preceding claims, wherein at least two Kerr-rings are provided that are arranged in parallel and/or in cascade to each other.

5. Integrated circuit according to any of the preceding claims, further comprising a sequence generation unit, which is configured to generate the modulation control signal for controlling the optical modulator.

6. Integrated circuit according to claim 5,
wherein the sequence generation unit is configured to generate a PRBS signal that is used for controlling the modulation of the optical modulator and/or wherein sequence generation unit is configured to operate the optical modulator in a divider mode and/or an arbitrary mode.

7. Integrated circuit according to claim 5 or 6,
wherein the sequence generation unit is configured to generate at least one modulation control signal that causes the optical modulator to generate modulated optical comb signals having at least two different power levels and/or having at least two discrete time shifts.

8. Integrated circuit according to any of the claim 5 to 7, wherein the the sequence generation unit comprises at least one control input for configuring and controlling the operation of the sequence generation unit, wherein the control input is coupled to at least one of the following:
- the pulse generation unit;
- a reset unit;
- a configuration unit;
- an external terminal for receiving an externally generated control signal.

9. Integrated circuit according to any of the preceding claims, further comprising at least one first photodiode, in particular a broadband photodiode, for generating an electrical comb signal from the modulated optical comb signal.

10. Integrated circuit according to any of the preceding claims,
further comprising at least one optical splitter and an optical output terminal connected to the optical splitter, wherein the optical splitter is configured to split the modulated optical comb signal and to feed the split modulated optical comb signal to the first photodiode and/or the optical output terminal.

11. Integrated circuit according to any of the preceding claims,
further comprising at least one of:
- at least one further optical modulator connected to the pulse generation unit for receiving the generated optical comb signal;
- at least one second photodiode connected to the sequence generation unit, wherein the sequence generation unit is configured to generate a timing trigger signal for the second photodiode;
at least one third photodiode directly connected to the output terminal of the pulse generation unit.

12. Integrated circuit according to any of the preceding claims,
further comprising a phased-locked loop circuit, which is configured to control the frequency of the pulse generation unit and/or the repetition rate generated by the integrated laser.

13. Integrated circuit according to any of the preceding claims,
further comprising an external optical input port for receiving an external optical signal and a switching unit, wherein in a first switching mode the switching unit is configured to connect the optical modulator to a first photodiode, and in a second switching mode the switching unit is configured to connect the external optical input port to the first photodiode.

14. Optical system, the optical system comprising:
at least one integrated circuit according to any of the preceding claims; and
at least one optical component, which is connected to the integrated circuit via an optical or electrical interface, wherein the at least one optical component comprises at least one of the following:
- an external laser connected via an optical input terminal to the pulse generation unit of the integrated circuit, which is configured to generate an optical high frequency signal;
- at least one external photodiode connected via an optical output terminal to the integrated circuit.

15. Test and measurement device comprising the integrated circuit according to any of the claims 1 to 13 and/or the optical system according to claim 14.
